# EUROPEAN PATENT APPLICATION

(11) **EP 4 773 185 A1**
(43) Date of publication of application: **08.07.2026**
(21) Application number: 25150284.5
(22) Date of filing: 06.01.2025
(51) Int. Cl.: H01L 23/473, H01L 23/46

(54) **PACKAGE SEMICONDUCTOR DEVICE AND METHOD OF MANUFACTURING IT**

(71) Applicant: NXP USA, Inc., Austin, TX 78735 (US)
(72) Inventor: VINCENT, Michael B., 5656AG Eindhoven (NL); GONG, Zhiwei, 5656AG Eindhoven (NL); HAYES, Scott M., 5656AG Eindhoven (NL)
(74) Representative: Colaiuda, Antonella

(57) **Abstract**

The present specification relates to package semiconductor devices and methods of manufacture thereof. According to a first aspect of the present disclosure, there is provided a packaged semiconductor device comprising a semiconductor die, a first molding compound encapsulating the semiconductor die, a first set of interconnecting solder balls, at least one redistribution layer, such redistribution layer connecting the semiconductor die to the interconnecting solder balls. The packaged semiconductor device further comprises at least one channel extending from the at least one redistribution layer to an exterior of the packaged semiconductor device wherein the at least one redistribution layer comprises pipes coupled to the at least one channel, such pipes transporting steam or moisture or thermal fluids from the at least one channel to the at least one redistribution layer or from the at least one redistribution layer to the at least one channel.

## Description

### TECHNICAL FIELD

The present specification relates to package semiconductor devices and methods of manufacture thereof. Without being limited thereto, it is of particular significance for package-in-package (PiP) semiconductors and for fan-out packaging semiconductors, especially fan-out wafer-level packaging semiconductors (FO-WLP) and fan-out panel-level packaging semiconductors (FO-PLP).

### BACKGROUND

Fan-Out (FO) packaging semiconductor may be defined as any package with connections fanned-out of the chip surface, enabling more external I/Os. FO-packaging semiconductor uses a mold compound to fully embed one or more semiconductor dies. A redistribution layer (RDL) is located atop the molded area and interconnecting solder balls are applied on top of the RDL. The RDL may further comprise dielectric layers (e.g. polyimide) for insulation purpose.

Embedding one package into another package is a technique known as package-in-package (PiP). PiP allows multi-dies and antenna/launcher integration with lower cost package options. The package to be embedded in the PiP may be a FO-WLP package or a FO-PLP.

### SUMMARY

Aspects of the disclosure are defined in the accompanying claims.

According to a first aspect of the present disclosure, there is provided a packaged semiconductor device comprising a semiconductor die, a first molding compound encapsulating the semiconductor die, a first set of interconnecting solder balls, at least one redistribution layer, such redistribution layer connecting the semiconductor die to the interconnecting solder balls, at least one channel extending from the at least one redistribution layer to an exterior of the packaged semiconductor device. The at least one redistribution layer comprises pipes coupled to the at least one channel, such pipes transporting steam or moisture or thermal fluids from the at least one channel to the at least one redistribution layer or from the at least one redistribution layer to the at least one channel.

In one or more embodiments, the pipes may be microfluidic channels.

In one or more embodiments, the pipes may be encapsulated in the at least one redistribution layer.

In one or more embodiments, the at least one redistribution layer may comprise dielectric layer.

In one or more embodiments, the at least one redistribution layer may be a multiple redistribution layer.

In one or more embodiments, the pipes may be open pipes.

In one or more embodiments, the pipes may comprise exterior walls and such exterior walls may consist of metal or dielectric or ceramic.

In one or more embodiments, the at least one channel may extend until a sidewall of the molding compound.

In one or more embodiments, the at least one channel may be a ventilation channel.

In a second aspect of the present disclosure, the packaged semiconductor device may further comprise: a packaged semiconductor device according to the first aspect of the disclosure, such package semiconductor being encapsulated in a second molding compound. The packaged semiconductor device further comprises a second set of interconnecting solder balls, an interposer located between the second set of interconnecting solder balls and the second molding compound.

In a third aspect, there is provided a method for manufacturing a packaged semiconductor device. The method may comprise the steps of: encapsulating the semiconductor die via a first molding compound, fixing the encapsulated semiconductor die to at least one redistribution layer, applying pipes to the at least one redistribution layer, forming at least one channel extending from the at least one redistribution layer through the first molding compound and, applying a first set of solder balls on the redistribution layer.

In one or more embodiments of the third aspect of the present disclosure, the method may further comprise the step of forming the at least one channel by laser drilling.

In one or more embodiments of the third aspect of the present disclosure, the method may further comprise the step of applying the pipes to the at least one redistribution layer via 3D printing.

In one or more embodiments of the third aspect of the present disclosure, the method may further comprise the step of fixing the pipes to the at least one redistribution layer via an adhesion layer.

In one or more embodiments of the third aspect of the present disclosure the method further comprises the steps of: connecting the first set of solder balls to an interposer, encapsulating the first molding compound, the pipes and the first set of solder balls via a second molding compound and applying a second set of solder balls on the interposer.

### DESCRIPTION OF DRAWINGS

Embodiments of the present specification will be described in more detail with reference to the appended drawings, in which:
Figure 1 shows a packaged semiconductor device according to a first embodiment of a first aspect the present disclosure.
Figure 1A shows a cross-sectional view of a packaged semiconductor device according to a first embodiment of a first aspect of the present disclosure.
Figure 1B shows a cross-sectional view of a packaged semiconductor device according to a first embodiment of a first aspect of the present disclosure.
Figure 2 shows a package-in-package semiconductor device according to a second aspect of the present disclosure.
Figure 3 shows a simplified flow chart according to a third aspect of the present disclosure.
Figure 3A shows a simplified flow chart according to another embodiment of a third aspect of the present disclosure.

It should be noted that the Figures are diagrammatic and not drawn to scale. Relative dimensions and proportions of parts of these Figures have been shown exaggerated or reduced in size, for the sake of clarity and convenience in the drawings. The same reference signs are generally used to refer to corresponding or similar features in modified and different embodiments.

### DESCRIPTION OF EMBODIMENTS

Fan-Out packaging uses a mold compound to fully embed one or more semiconductor die, followed by one or more redistribution layer (RDL) atop the molded area (chip and fan-out area). Interconnecting solder balls are then applied on top of the RDL. The RDL may further comprise dielectric layers (e.g. polyimide) for insulation purpose. The dielectric layers may consist of polyimide. At ambient conditions (or enhanced moisture environments), moisture may be absorbed into all or some of the dielectric layers, especially the ones composed of polyimide. The expansion of trapped moisture, for example under high-temperature, or low-pressure, conditions, may result in internal separation (also known as delamination) of the plastic from the die, between layers of dielectric, or between dielectric and metal of the RDL, or between mold compound and RDL. Additional or alternatively, the expansion of trapped moisture may result in die damage, internal cracks and so on. If the trapped moisture cannot release rapidly, pressure builds up and puts excessive pressure on the component surface too. In extreme cases, the component surface will bulge and pop. This is known as the "popcorn" effect. This effect may occur when the temperature rises rapidly to a high maximum, i.e. above 100°C, during the soldering (assembly) process.

The "popcorn" effect may occur in the package-in-package semiconductor device too. In package-in-package semiconductor device, the RDL may connect at least one semiconductor die to interconnecting solder balls for enabling the assembling on the next level substrate (for example an interposer). In this case too, dielectric layers (e.g. polyimide) are used for insulating among and between the RDLs. As described above, moisture may be absorbed into some or all dielectric layers, especially in the case of polyimide (PI) or similar thermoset resins, and upon subsequent rapid thermal events, such as solder reflow, the moisture turns to steam therefore expanding. If the steam cannot release rapidly, pressure builds up and can cause material interfaces and component surfaces to fail and crack.

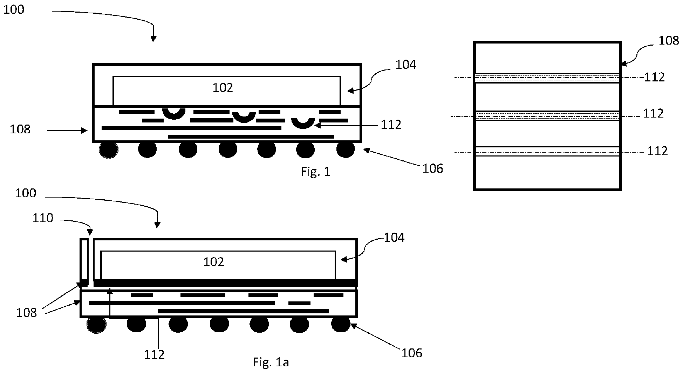

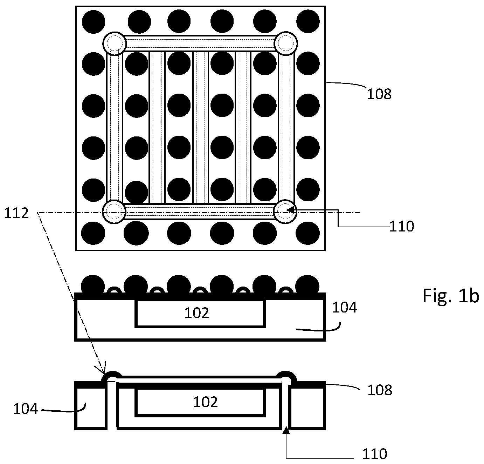

Fig. 1 shows a packaged semiconductor device 100 according to a first aspect of the present disclosure and a planar view of the redistribution layer 108 with the pipes 112 embedded therein. The packaged semiconductor device 100 includes a semiconductor die 102 and a first molding compound 104 encapsulating the semiconductor die 102. The packaged semiconductor device further includes a first set of interconnecting solder balls 106 and at least one redistribution layer (RDL) 108. The redistribution layer 108 is usually a wiring layer, which is used to input and output information to and from an integrated circuit chip, respectively. The RDL structure may comprise plural conductor layers and may include vias, traces and other types of conductor structures suitable for RDL fabrication. The vias, traces and other types of conductor structure may be constructed of copper, silver, aluminum, gold, platinum, palladium, combinations of such or other conductors, or of metal containing polymers, and be fabricated using well-known material deposition techniques, such as plating, sputtering, chemical vapor deposition, printing, dispensing, jetting, combinations of these or the like and patterned as necessary using well-known photolithography and directional etching techniques. The RDL structure may include one or more dielectric layers. The dielectric layers may consist in part or entirely of polyimide.

The RDL connects the semiconductor die to a first set of interconnecting solder balls 106. The solder balls, which may be also called solder bumps, are balls of solder that provide the contact between the chip package and the printed circuit board. The solder balls may have any of a variety of cross-sectional shapes, including a circular or elliptical cross-section, a substantially rectangular cross-section, a stadium (or pillar-shaped) cross-section, an n-sided polygonal cross-section, or the like. The solder balls may be constructed of copper or silver, aluminum, gold, platinum, palladium, or by combinations of such or other conductors.

The RDL further includes pipes 112, represented as semicircles in Figure 1. The pipes may intersect each other, forming a pattern. The pattern may have any of a variety of shapes including rectangular-shape, triangular-shape, circular-shape or the like. The pipes have exterior walls. The pipe's exterior walls may consist of a variety of materials, like for example metal or dielectric or ceramic or copper.

The pipes may be open or closed. Closed pipes are defined as ones where all walls are solid, whereas open pipes lack at least a wall, such as a top. Open pipes may exhibit various cross-sectional geometries, including for example circular or elliptical cross-section, a substantially rectangular or quadratic cross-section, a trapezoidal or U-shaped or V-shaped cross-section or the like. The lack of a top provides access to the inside of the pipe. The pipes are further coupled to at least one channel 110. The pipes are configured to transport steam or moisture or thermal fluids from the at least one channel to the at least one redistribution layer or from the at least one redistribution layer to the at least one channel.

The term "thermal fluids" may refer to liquid/gases/vapors which are able to transport and transfer heat. The circulation of the thermal fluids in the RDL reduce the temperature of the RDL and has therefore a cooling function.

The packaged semiconductor device further includes at least one channel 110. The channel may be a ventilation channel. The channel may extend from the pipes to the exterior of the packaged semiconductor. In an embodiment of the present disclosure, the channel may extend through the first molding compound of the packaged semiconductor until the exterior of the semiconductor package.

In one embodiment, the at least one channel extends from the pipes to the exterior of the packaged semiconductor device. In this way the steam or moisture may flow outside the packaged semiconductor device. This has the effect to eliminate or dissipate the steam or moisture that may be generated in the RDL during rapid thermal events. By dissipating the steam or moisture, the risk of increasing pressure on the material interfaces and component surfaces of the packaged semiconductor device is considerably reduced and, therefore, the likelihood of failure of the material interfaces/component surfaces may be significantly reduced, and in particular the popcorn effect may be avoided.

In another embodiment, the channel may be completely embedded in the packaged semiconductor device (i.e. the channel has no aperture towards the exterior of the packaged semiconductor device). In this embodiment, the channel and the pipes form a closed circuit in which the steam or moisture or thermal fluids may flow. This has the effect to diffuse the steam or moisture from region(s) where their concentration is higher to region(s) where their concentration is lower. By diffusing the steam or moisture, the risk of increasing pressure on the material interfaces and/or on the component surfaces of the packaged semiconductor device is considerably reduced and, therefore the likelihood of failure of the material interfaces/component surfaces may be significantly reduced.

In one embodiment, more than one channel 110 may be present. This has the effect to increase the ventilation paths and therefore to improve the dissipation of the steam or moisture or the circulation of the thermal fluids.

In one embodiment, the pipes 112 may be microfluidic channels. Microfluidic channels are configured for transporting a small amount of fluids (usually between 10⁻⁹ to 10⁻¹⁸ liters) using channels with diameters comprised of ten to hundreds of micrometers. The microfluidic channels may have any of a variety of cross-sectional shapes, including a circular or elliptical cross-section, a substantially rectangular or quadratic cross-section, a trapezoidal, U-shaped and V-shaped cross-section or the like. The microfluidic channels 112 are coupled to the at least one channel 110 and are configured for transporting thermal fluids from the at least one channel 110 to the at least one redistribution layer 108 or from the at least one redistribution layer 108 to the at least one channel 110. The thermal fluids may have a cooling function: by circulating in the RDL, they acts as a heat-spreader and reduce the temperature of the hottest parts of the RDL. The thermal fluid may absorb moisture or steam generated in the dielectric layer as well. The flow of the thermal fluids has therefore the effect of cooling the dielectric layer, reducing in this way the risk of failure of either material interfaces or component surfaces of the packaged semiconductor device. In a further embodiment, when the channel 110 extends from the microfluidic channels to the exterior of the packaged semiconductor device, the thermal fluids may be injected into the channel from the exterior of the semiconductor device.

Fig. 1A shows a cross-sectional view of the packaged semiconductor device in a further embodiment of the first aspect of the present disclosure. In the depicted embodiment the channel 110 extends until the sidewalls of the packaged semiconductor. The redistribution layer 108 may be a multiple redistribution layer, i.e. it may include more than one redistribution layer. The redistribution layers may be stacked on each other. The spaces between redistribution layer may be filled with dielectric material, like for example polyimide. The pipes 112 are embedded in the redistribution layer and are coupled to the channel 110.

Fig. 1B shows a cross-sectional view of the packaged semiconductor device according to a further embodiment of the of the first aspect of the present disclosure. The figure shows planar view of the redistribution layer 108 with the pipes 112 embedded therein. In this particular embodiment the redistribution layer 108 may consist of a single layer or may be a multiple distribution layer, consisting of more than one redistribution layer. The pipes form a rectangular pattern, which is embedded in the redistribution layer. The channel 110 is coupled to the pipes and extends through a first compound of the semiconductor device. The pipes 112 and the channel 110 form a circulation pattern and are configured to transport steam or moisture or thermal liquids.

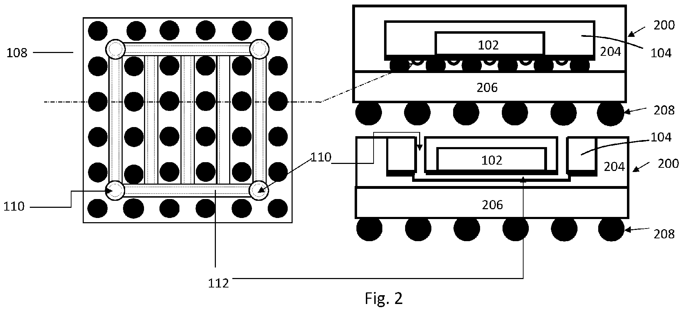

Fig. 2 shows a package-in-package semiconductor device according to a second aspect of the present disclosure. The package-in-package semiconductor device 200 includes a first packaged semiconductor device. The packaged semiconductor device may be a packaged semiconductor device as described in the first aspect of the present disclosure. In particular, the packaged semiconductor device may be a fan-out WLP device or a fan-out PLP.

The first packaged semiconductor device may include a semiconductor die 102 encapsulated in a first molding compound 104. One or more redistribution layers are attached to the semiconductor die. The semiconductor die 102, the first molding compound 104, the one or more redistribution layers 108 and the solder balls 106 are encapsulated in a second molding compound 204. An interposer 206 is located between the first set of solder balls 106 and a second set of solder balls 208. Like the first set of solder balls, the second set solder balls may have any of a variety of cross-sectional shapes, including a circular or elliptical cross-section, a substantially rectangular cross-section, a stadium (or pill-shaped) cross-section, an n-sided polygonal cross-section, or the like. The interposer may comprise either inorganic (silicon, glass, or the like) or organic (FR4-like) material.

The redistribution layer includes pipes 112: the pipes are configured to transport steam or moisture, generated in the RDL during rapid thermal events. The pipes are coupled to at least one channel 110. In one embodiment the at least one channel may extend through the second and the first molding compound. In another embodiment the at least one channel may extend until the exterior of the package-in-package semiconductor device. The at least one channel may be a ventilation channel.

In one embodiment the at least one channel may extend through the second molding compound as well as through the first molding compound and may reach the exterior walls of the package-in-package device without crossing them. In this particular embodiment, the at least one channel then forms with the pipes a closed circuit configured to circulate, but not vent, the steam or moisture generated in the RDL during rapid thermal events. This has the effect to diffuse the steam or moisture from region(s) where their concentration is higher to region(s) where their concentration is lower. By diffusing the steam or moisture, the risk of failure of the either material interfaces or component surfaces of the packaged semiconductor device

In another embodiment the at least one channel may extend to the exterior of the package-in-package semiconductor device. In this embodiment the at least one channel extends through the second molding compound as well as through the first molding compound and crosses the exterior walls of the package-in-package device. In this way the steam may be brought outside the packaged semiconductor device. This has the effect to produce a better dissipation, reducing in this way the risk of failure of either material interfaces or component surfaces of the packaged semiconductor device. In a further embodiment, thermal fluids may be injected into the channel from the exterior of the semiconductor device. The thermal fluids are then transported from the channel to the RDL via the pipes. The thermal fluids have a cooling function: by circulating in the RDL, they reduce the temperature of the RDL. The thermal fluid may absorb moisture or steam generated in the dielectric layer as well.

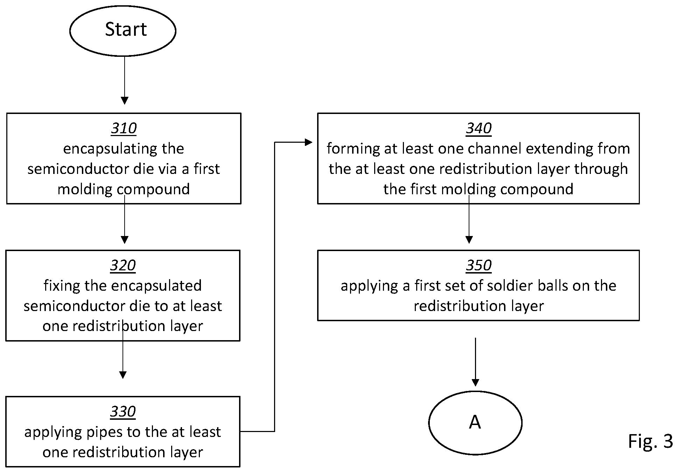

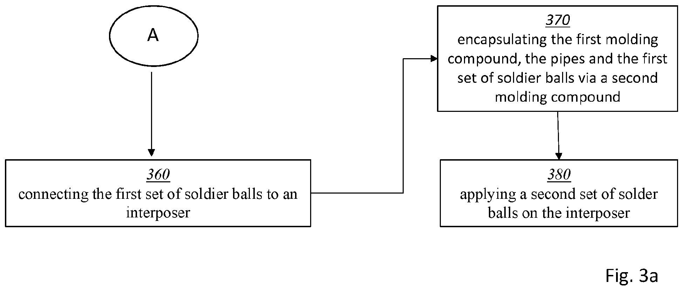

Fig. 3 shows an illustrative flow chart representing a manufacturing method according to a third aspect of the present disclosure. The method includes the steps of: encapsulating (310) a semiconductor die via a first molding compound, fixing (320) the encapsulated semiconductor die to at least one redistribution layer, applying (330) pipes to the at least one redistribution layer, forming (340) at least one channel extending from the at least one redistribution layer through the first molding compound and applying (350) a first set of solder balls on the redistribution layer.

In a further embodiment, the pipes are applied to the at least one redistribution layer by a 3D printing process. Preferably, the 3D printing process is performed on a copper (Cu) foil. In one embodiment, the 3D printing process may be an electrochemical additive manufacturing (ECAM) process. ECAM is a roomtemperature 3D metal printing method, which creates micro to nanostructures layer by layer using the principle of electrodeposition between an anode and cathode submerged in a metal plating bath solution. An externally applied voltage bias may drive the ions in the solution to migrate to the substrate near the printer head and form a solid deposit on the substrate.

In a further embodiment, the pipes may be attached to the redistribution layer via an adhesive layer. The use of adhesive layers is particularly convenient if two components of different materials are bonded together.

Fig. 3A shows an illustrative flow chart representing a manufacturing method according to a second embodiment of the third aspect of the present disclosure. The depicted manufacturing method may be used for manufacturing package-in-package devices. The method may include the steps of manufacturing a packaged semiconductor device according to the first embodiment of the third aspect of the present disclosure. The packaged semiconductor device may be a fan-out wafer-level-packaging (FO-WLP) or a fan-out panel-level packaging (FO-PLP). The method further includes the step of connecting (360) the first set of solder balls of the packaged semiconductor device to an interposer and of encapsulating (370) the packaged semiconductor device via a second molding compound. The method further includes the step of applying (380) a second set of solder balls on the interposer. The method may further include the step of connecting at least one printed circuit board (PCB) to the second set of solder balls. In another embodiment, the solder balls could be applied to the interposer during board assembly when the package is assembled to the at least one printed circuit board.

From reading the present disclosure, other variations and modifications will be apparent to the skilled person. Such variations and modifications may involve equivalent and other features which are already known in the art of semiconductor device processing, and which may be used instead of, or in addition to, features already described herein.

Although the appended claims are directed to particular combinations of features, it should be understood that the scope of the disclosure of the present specification also includes any novel feature or any novel combination of features disclosed herein either explicitly or implicitly or any generalization thereof, whether or not it relates to the same specification as presently claimed in any claim and whether or not it mitigates any or all of the same technical problems as does the present specification

The present disclosure refers to elements or features being "connected" or "coupled" together. As used herein, unless expressly stated otherwise, "connected" means that one element is directly joined to (or directly communicates with) another element, and not necessarily mechanically. Likewise, unless expressly stated otherwise, "coupled" means that one element is directly or indirectly joined to (or directly or indirectly communicates with, electrically or otherwise) another element, and not necessarily mechanically. Thus, although the schematic shown in the figures depict one exemplary arrangement of elements, additional intervening elements, devices, features, or components may be present in an embodiment of the depicted subject matter.

Features which are described in the context of separate embodiments may also be provided in combination in a single embodiment. Conversely, various features which are, for brevity, described in the context of a single embodiment, may also be provided separately or in any suitable sub-combination. The applicant hereby gives notice that new claims may be formulated to such features and/or combinations of such features during the prosecution of the present application or of any further application derived therefrom.

For the sake of completeness, it is also stated that the term "comprising" does not exclude other elements or steps, the term "a" or "an" does not exclude a plurality, a single processor or other unit may fulfil the functions of several means recited in the claims and reference signs in the claims shall not be construed as limiting the scope of the claims. Furthermore, the word "may" is used in a permissive sense (i.e., meaning having the potential to), rather than the mandatory sense (i.e., meaning must). Similarly, the words "include," "including," and "includes" mean including, but not limited to. Unless stated otherwise, terms such as "first" and "second" are used to arbitrarily distinguish between the elements such terms describe. Thus, these terms are not necessarily intended to indicate temporal or other prioritization of such elements.

## Claims

1. A packaged semiconductor device comprising:
a semiconductor die,
a first molding compound encapsulating the semiconductor die,
a first set of interconnecting solder balls,
at least one redistribution layer connecting the semiconductor die to the first set of interconnecting solder balls,
at least one channel extending from the at least one redistribution layer to an exterior of the packaged semiconductor device,
wherein
the at least one redistribution layer comprises pipes coupled to the at least one channel, such pipes configured to transport steam or moisture or thermal fluids from the at least one channel to the at least one redistribution layer or from the at least one redistribution layer to the at least one channel.

2. The packaged semiconductor device according to claim 1 wherein the pipes are microfluidic channels.

3. The packaged semiconductor device according to any of the preceding claims wherein the pipes are encapsulated in the redistribution layer.

4. The packaged semiconductor device according to any of the preceding claims wherein the at least one redistribution layer comprises dielectric layers.

5. The packaged semiconductor device according to any of the preceding claims wherein the at least one redistribution layer is a multiple redistribution layer.

6. The packaged semiconductor device according to any of the preceding claims wherein the pipes are open pipes.

7. The packaged semiconductor device according to any of the preceding claims, wherein the pipes comprise exterior walls and such exterior walls are comprised of metal or dielectric or ceramic.

8. The packaged semiconductor device according to any of the preceding claims wherein the at least one channel extends until a sidewall of the first molding compound.

9. The packaged semiconductor device according to any of the preceding claims wherein the at least one channel is a ventilation channel.

10. A package-in-package semiconductor device comprising:
the packaged semiconductor device according to claim 1 to 9,
a second molding compound encapsulating the packaged semiconductor device,
a second set of interconnecting solder balls,
an interposer located between the second set of interconnecting solder balls and the second molding compound.

11. A method of manufacturing a packaged semiconductor device, the method comprising
encapsulating a semiconductor die via a first molding compound,
fixing the encapsulated semiconductor die to at least one redistribution layer,
applying pipes to the at least one redistribution layer,
forming at least one channel extending from the at least one redistribution layer through the first molding compound,
applying a first set of solder balls on the at least one redistribution layer.

12. The method according to claim 11 wherein the at least one channel is formed by laser drilling.

13. The method according to claim 11 or claim 12 wherein the pipes are applied to the redistribution layer via 3D printing.

14. The method according to claims 11 to 13 wherein the pipes are fixed to the redistribution layer via an adhesion layer.

15. A method of manufacturing a package-in-package semiconductor device, the method comprising the steps of:
manufacturing a packaged semiconductor device according to claims 10 to 14,
connecting the first set of solder balls of the packaged semiconductor device to an interposer,
encapsulating the packaged semiconductor device via a second molding compound,
applying a second set of solder balls on the interposer.
